# EUROPÄISCHE PATENTANMELDUNG

(11) **EP 3 550 686 A1**
(43) Veröffentlichungstag der Anmeldung: **09.10.2019**
(21) Anmeldenummer: 19000132.1
(22) Anmeldetag: 15.03.2019
(51) Int. Cl.: H02G 15/013, H02K 5/12, H05K 5/06, H05K 1/02, H02G 3/22, H02K 5/22

(54) **DURCHFÜHRUNG VON STROMFÜHRENDEN LEITUNGEN ZUR HERMETISCHEN TRENNUNG ZWEIER MEDIEN UND VERFAHREN ZUR HERSTELLUNG DERSELBEN**

(30) Priorität: 15.03.2018 DE 102018002076
(71) Anmelder: Binder, Siegfried, 31787 Hameln (DE)
(72) Erfinder: Binder, Siegfried, 31787 Hameln (DE)
(74) Vertreter: Szaunig, Bernd

(57) **Zusammenfassung**

Mit der vorliegenden Erfindung wird eine tunnelartige Durchführung (1, 1') von elektrischen Leitungen (2") bei hermetischer Trennung zweier Medien (A, B) vorgestellt. Derartige tunnelartigen Durchführungen finden häufig im Unterwasserbereich eine Anwendung, zum Beispiel zum Antrieb eines Unterwassermotors (10), der eine starke Flüssigkeitsströmung erzeugt. In der erfindungsgemäßen tunnelförmige Durchführung (1, 1') ist eine Leiterplatte (3, 3') angeordnet, die von einer Vergussmasse (4) zumindest teilweise umgeben ist, wodurch der Raum A eines Mediums, zum Beispiel Luft, vom Raum B eines anderen Mediums, zum Beispiel Wasser, hermetisch abgeschlossen und getrennt wird.

## Beschreibung

Die vorliegende Erfindung befasst sich mit einer Durchführung von stromführenden Leitungen zur hermetischen Trennung zweier Medien, sowie einem Verfahren zur Herstellung derselben, insbesondere mit einer Durchführung von mindestens einem elektrischen Leiter von einem Medium A in ein anderes Medium B, das bedeutet die wasserdichte Durchführung von stromführenden Leitungen eines mehradrigen Kabels.

Derartige Durchführungen sind im Stand der Technik aus der Druckschrift DE 198 52 189 A1 in Bezug auf die vorliegende Erfindung bekannt geworden. Diese Druckschrift offenbart ein Kabelverbindungsmodul zum Anschließen einer Sensor-/Aktor-Einheit an einen Stromkreis mit mindestens zwei Eingangsleitungen, die an einer Strom-/Spannungsbegrenzungseinrichtung in einem Gehäuse angeschlossen sind. Von dieser Strom-/Spannungsbegrenzung Einrichtung führen mehrere Leitungen aus dem Gehäuse heraus und dienen als nicht eigengesicherte Stromzuführung eines Gerätes. Dabei sind vermutlich die Bauteile der Strom-/Spannungsbegrenzungseinrichtung auf einer Platine angeordnet, die elektrische Kontakte aufweist, an die die jeweiligen Kabelenden angeschlossen sind. Als nachteilig wird es u.a. empfunden, dass die Enden der Isolierung der einzelnen Adern und der Ummantelung des Kabels die in das Innere des Gehäuses hineinragen, nicht von einer Vergussmasse umgeben sind, was für die Vermeidung von Diffusionsvorgängen von Feuchtigkeit von Bedeutung ist. Als nachteilig an dieser Erfindung wird es weiterhin empfunden, dass die Leiterplatte vollständig von der Vergußmasse umgeben ist, so dass die Anschlusskontakte für eine weitere Verarbeitung nicht mehr zugänglich sind.

Ferner zeigt die Druckschrift DE 10 2014 116 387 A1 ein elektrisches Anschlusskabel für die Montage in einer Öffnung eines Leuchtenmoduls, bei dem eine Durchführung für elektrische Leitungen mit einer Leiterplatte gezeigt wird, die die kabelförmige Leitung innerhalb der Durchführung einmal unterbricht, wobei die einzelnen Adern des Kabels und die elektrischen Kontakte auf der Leiterplatte von einer Vergußmasse umgeben sind, Das Steckergehäuse ist im wesentlichen tunnelartig ausgebildet, wobei die Leiterplatte teilweise von einer Vergußmasse umgeben ist, die einerseits die Leiterplatte an dem Gehäuse befestigen und andererseits das Eindringen von Feuchtigkeit verhindern soll. Nachteilig könnte es aber sein, dass das Eindringen von Feuchtigkeit mit dem Kabelstecker vermutlich nicht verhindert werden kann, weil weder das Ende der Ummantelung des Kabels vollständig von der Vergußmasse umgeben ist, noch die Innenwände des Gehäuses und die Oberfläche der Leiterplatte eine wasserdichte Haftschicht bilden, sodass nicht sichergestellt ist, dass eine hermetische Abdichtung des einen Mediums zum anderen Medium gewährleistet ist.

Aus der DE 103 50 724 A1 wurde eine Kabelanschlußeinheit für technische Geräte bekannt, die mit einer Dichtmasse vergossen ist, wodurch erhebliche Fertigungshindernisse entstehen, weil sämtliche elektrischen Kontakte von der Vergußmasse umgeben sind, so dass diese für eine weitere Verarbeitung nicht mehr zugänglich sind.

Die DE 35 07 926 A1 zeigt darüber hinaus eine Koppeldurchführung zur Durchleitung von elektrischen Steuersignalen mit einer Hülse, in der eine Vielzahl von Steuerleitungen angeordnet sind, die alle mit einem Gießharz vergossen sind.

Weiterhin ist aus der deutschen Patentschrift DD 300 499 A7 eine Kabeldurchführung in einem wasserdicht vergossenen Verteiler bekannt geworden, bei dem die Leitungsverbindungen zur wasserdichten Umhüllung mit einem geeigneten Vergussmaterial vergossen werden, wobei auf die Oberfläche der Kabelisolation ein Gummiring aufgeschoben wird, um die Wasserdichtigkeit zu gewährleisten. Derartige Kabel Durchführungen haben allerdings den Nachteil, dass sie nicht über einen längeren Zeitraum unter Wasser bei einem gewissen Wasserdruck die Diffusion von Feuchtigkeit in das Innere des Verteilers verhindern können.

Ferner ist aus der WO 2015/075029 A1 eine Eisfrei-Matte bekannt geworden, die aus einer elektrisch isolierenden Grundplatte und einem Folien-Heizwiderstand, sowie einer darüber liegenden isolierenden Deckplatte, die miteinander verklebt sind, gebildet wird. Dabei ist die Stromzuführung zu dem Folien-Heizwiderstand in einer Aussparung miteinander verbunden, wobei die Aussparung mit einem geeigneten Kleber vergossen und mit der Grundplatte und der Deckplatte verklebt wird. Auch diese Stromzufuhr-Einrichtung hat den Nachteil, dass sie für eine längere Zeit unter Wasser unbrauchbar und darüber hinaus ungeeignet für variable Anschlüsse von stromführenden Kraftstromleitungen bzw. Steuerleitungen ist.

Als nachteilig an den im Stand der Technik bekannt gewordenen Strom-Durchführungen von einem Medium, wie beispielsweise der atmosphärischen Luft oder Vakuum, in einen von Wasser umgebenen Raum, ist es in der Praxis unmöglich, über einen längeren Zeitraum eine Feuchtigkeitsdiffusion zu verhindern, so dass die in den Innenraum eingedrungene Feuchtigkeit sowohl die Funktion eines Getriebes als auch die elektrische Funktion eines möglichen Antriebs zumindest beeinträchtigen.

Ausgehend vom oben dargelegten Stand der Technik, liegt der vorliegenden Erfindung die Aufgabe zugrunde, eine Durchführung und ein Verfahren für elektrischen Strom führende Leitungen bereitzustellen, die in der Lage sind, dauerhaft unter Wasser liegende Stromdurchführungen hermetisch abzudichten, damit keine Feuchtigkeit in das Innere eines Hohlraums, in dem empfindliche Getriebe und Elektronik angeordnet sind, diffundieren kann.

Diese Aufgabe wird mit den kennzeichnenden Merkmalen der Hauptansprüche gelöst.

Erfindungsgemäß ist die Durchführung von stromführenden Leitungen, die mindestens zwei Medien (A, B) voneinander trennt und mindestens eine elektrische kabelförmige Leitung von einem Medium (B) in ein anderes Medium (A) führt, wobei mindestens eine Leiterplatte, die die elektrische kabelförmige Leitung innerhalb der Durchführung mindestens einmal in der Durchführung unterbricht, dadurch gekennzeichnet, dass die Enden der Isolierung der einzelnen Adern eines Kabels und der Ummantelung, sowie die elektrischen Kontakte auf der Leiterplatte mindestens teilweise von einer Vergußmasse umgeben sind und die Innenwände eines tunnelartigen Aufbaus und die Oberfläche der Leiterplatte mindestens teilweise mit der Vergussmasse eine wasserdichte Haftschicht bilden, die lange Zeit beständig ist.

Dabei ist es vorteilhaft, dass die Vergussmasse mit der Oberfläche der Leiterplatte eine feuchtigkeitsundurchlässige Verbindung eingeht.

Weiterhin ist es vorteilhaft, dass die Lackschicht mit der Vergussmasse eine Verbindung bildet, die das Medium A vom Medium B sicher trennt und langzeitbeständig ist.

Auch ist es vorteilhaft, dass die tunnelartige Konstruktion an einen Flansch angeordnet ist und der Flansch an einem Gehäuse befestigt ist, in dem ein Motor mit einem Getriebe angeordnet ist.

Ferner ist es vorteilhaft, dass auf der nach innen weisenden Flanschfläche des Flansches ein rohrförmiger Aufsatz angeordnet ist, der mit einer Bohrung im Flansch fluchtet.

Auch ist es vorteilhaft, dass auf der nach außen weisenden Flanschfläche ein hohler Aufbau angeordnet ist.

Ein weiterer Vorteil ist darin zu sehen, dass auf der nach außen weisenden Flanschfläche eine Verschraubung angeordnet ist, die ein mehradriges Kabel aufnimmt.

Ein weiterer Vorteil besteht darin, dass auf beiden Seiten der Leiterplatte elektrische Leiterbahnen angeordnet sind, wobei auf der einen Seite der Leiterplatte die Kraftstrom führenden Leitungen und auf der anderen Seite die Steuerleitungen angeordnet sind.

Vorteilhaft ist es ferner, dass die Leiterbahnen auf beiden Seiten der Leiterplatte Verbindungsstellen aufweisen, an denen die entsprechenden Kabelenden elektrisch verbunden sind.

Das erfindungsgemäße Verfahren zur Herstellung einer absolut wasser- und feuchtigkeitsdichten Durchführung von stromführenden Leitungen, die mindestens zwei Medien voneinander trennt und mindestens eine elektrische kabelförmige Leitung von einem Medium (B) in ein anderes Medium (A) führt, wobei mindestens eine Leiterplatte, die elektrische kabelförmige Leitung innerhalb der Durchführung mindestens einmal in der Durchführung unterbricht, so dass die Enden der Isolierung der einzelnen Adern eines Kabels, sowie die Ummantelung und die elektrischen Kontakte auf der Leiterplatte von einer Vergußmasse umgeben sind, zeichnet sich dadurch aus, dass eine auf der gesamten Oberfläche beschichteten Leiterplatte zumindest teilweise in einen rohrförmigen Aufbau eingeführt wird und anschließend der Hohlraum des rohrförmigen Aufbaus zumindest teilweise mit einer geeigneten Vergußmasse vergossen wird, wobei mit der auf der gesamten Oberfläche der Leiterplatte aufgebrachten Schicht mit der Vergußmasse eine wasserdichte Verbindung gebildet wird.

Weitere vorteilhafte Eigenschaften und Merkmale sind den Unteransprüchen und der Beschreibung zu entnehmen.

Im nun folgenden wird die Erfindung anhand von Zeichnungen im Detail näher beschrieben. Es zeigt
- Fig. 1: eine Seitenansicht eines schematischen Aufbaus der tunnelartigen Durchführung (1), bei der eine Leiterplatte (3) und die elektrischen Kontakte (5) auf der Leiterplatte (3) von einer Vergussmasse (4) umgeben sind;
- Fig. 2: eine schematische Vorderansicht einer runden tunnelartigen Durchführung (1), bei der die Leiterplatte (3) und die elektrischen Kontakte (5, 5') von einer speziellen Lackschicht (6) überzogen sind;
- Fig. 3: eine schematische Vorderansicht einer mehreckigen tunnelartigen Durchführung (1), bei der die Leiterplatte (3) und die elektrischen Kontakte (5, 5') von einer speziellen Lachschicht (6) überzogen sind;
- Fig. 4: die Draufsicht auf eine Seite der Leiterplatte (3) mit den kraftstromführenden Leiterbahnen (2);
- Fig. 5: die Draufsicht auf die andere Seite der Leiterplatte (3) mit den Steuerleiterbahnen (2');
- Fig. 6: eine schematische Schnittdarstellung eines Systems (11) mit einem Gehäuse (9), an das an einem Ende die erfindungsgemäße tunnelartige Durchführung (1) angeflanscht ist;
- Fig. 7: eine schematische Seitenansicht eines Ausführungsbeispiels, bei der die Leiterplatte (3') quer zu Längsachse des Kabels (18) angeordnet ist.

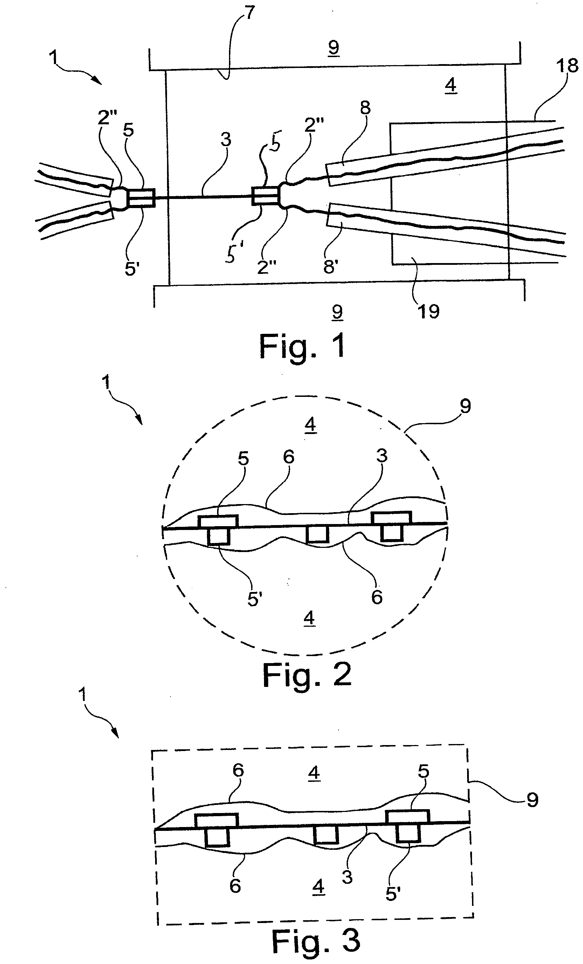

Die Fig. 1 zeigt eine schematische Seitenansicht des Aufbaus einer erfindungsgemäßen tunnelartigen Durchführung 1, bei der eine Leiterplatte 3, sowie die darauf aufgebrachten Leiterbahnen 2, 2' (hier nicht sichtbar) und die elektrischen Kontakte 5, 5', teilweise von einer Vergussmasse 4 umgeben sind. Die elektrischen Kontakte 5, 5' sind mit elektrischen Zufuhr- und Abgangsleitungen 2" verbunden, die den ankommenden und abgehenden Strom führen. In die tunnelartige Durchführung 1 ist im vorliegenden Ausführungsbeispiel eine Leiterplatte 3 zumindest teilweise eingeführt. Auf der Leiterplatte 3 befinden sich beidseitig aufgebrachte elektrische Leiterbahnen 2, 2', wie weiter unten näher beschrieben wird. Im vorliegenden Ausführungsbeispiel ist die Leiterplatte 3 mit mindestens einem elektrischen Kontakt 5 teilweise von einer Vergussmasse 4 umschlossen, wobei die elektrischen Zu- und Abgangsleitungen 2" an den elektrischen Kontakten 5, 5' angeschlossen sind. Die elektrischen kabelförmigen Leitungen 2" sind von einer Isolierung 8, 8' umgeben, deren Enden ebenfalls von der Vergussmasse 4 vollständig abgedichtet sind, sodass eine mögliche Feuchtigkeit über die elektrischen kabelförmigen Leitungen 2" nur bis zum Ende der Isolierung 8, 8' gelangen kann. Ähnlich verhält es sich mit einer möglichen Feuchtigkeitsdiffusion zwischen der Isolierung 8, 8' der einzelnen Adern des Kabels 18 und der Ummantelung 19, deren Enden auch vollständig von der Vergussmasse 4 verschlossen sind, sodass ein weiteres Vordringen der mögliche Feuchtigkeit verhindert wird. Aufgrund der getroffenen Maßnahmen, sind einerseits alle elektrischen Leitungen 2" eines Kabels 18 durch eine Leiterplatte 3, 3' unterbrochen und andererseits liegen die Enden der Isolierung 8, 8' der einzelnen elektrischen Leitungen 2", sowie der Ummantelung 19 im Innern der Vergussmasse 4. Damit ist das Durchdringen (Diffusion) von Feuchtigkeit in das Innere des Raumes A unmöglich geworden, was für die Standzeit der mechanischen und elektrischen Bauteile innerhalb des Raumes A von ausschlaggebender Bedeutung ist. Beim Eingießen der speziellen Vergußmasse 4 wird also die gesamte Oberfläche der Leiterplatte 3 und die Enden der elektrischen Zufuhrleitungen, sowie die Innenseite 7 der tunnelartigen Durchführung 1 hermetisch verschlossen und damit eine absolut wasser-und feuchtigkeitsdichte abgeschlossene Trennung zwischen dem Raum A und dem Raum B hergestellt. Dabei spielt es keine Rolle, ob die Vergussmasse bis an die Kanten bzw. Ränder der tunnelartigen Durchführung 1 herangeführt wird oder nicht. Entscheidend ist u.a., dass die Vergussmasse 4 mit einer auf der Oberfläche der Leiterplatte 3 aufgebrachten Lackschicht 6 eine feuchtigkeitsundurchlässige Schicht bildet, die den Raum A vom Raum B hermetisch abgeschirmt.

Die Figur 2 zeigt eine schematische Vorderansicht einer runden tunnelartigen Durchführung 1, bei der die Leiterplatte 3 und die elektrischen Kontakte 5, 5' von einer speziellen Lackschicht 6 überzogen sind. Die spezielle Lackschicht 6 dient dazu, dass einerseits die Oberfläche der Leiterplatte 3 mit den elektrischen Kontakten 5, 5' nicht unmittelbar beim Vergießen der Vergussmasse von der Vergussmasse 4 berührt werden, sondern, dass die Vergussmasse 4 mit der Lackschicht 6 eine (chemische) Verbindung eingeht, die sowohl feuchtigkeitsundurchlässig ist, als auch eine Schutzschicht für die Oberfläche der Leiterplatte 3 und der elektrischen Kontakte 5, 5' bildet.

Die gleiche Situation wird für eine mehreckige tunnelartige Durchführung in Figur 3 schematisch dargestellt. Der Unterschied im Vergleich zur runden Durchführung aus Figur 2 besteht darin, dass der Querschnitt der tunnelartigen tunnelförmigen Durchführung 1 besonders gut für mehreckige Leiterplatten geeignet ist, woraus folgt, dass der Querschnitt der tunnelförmigen Durchführung 1 frei wählbar ist und sich nach dem jeweiligen Anwendungsfall richtet.

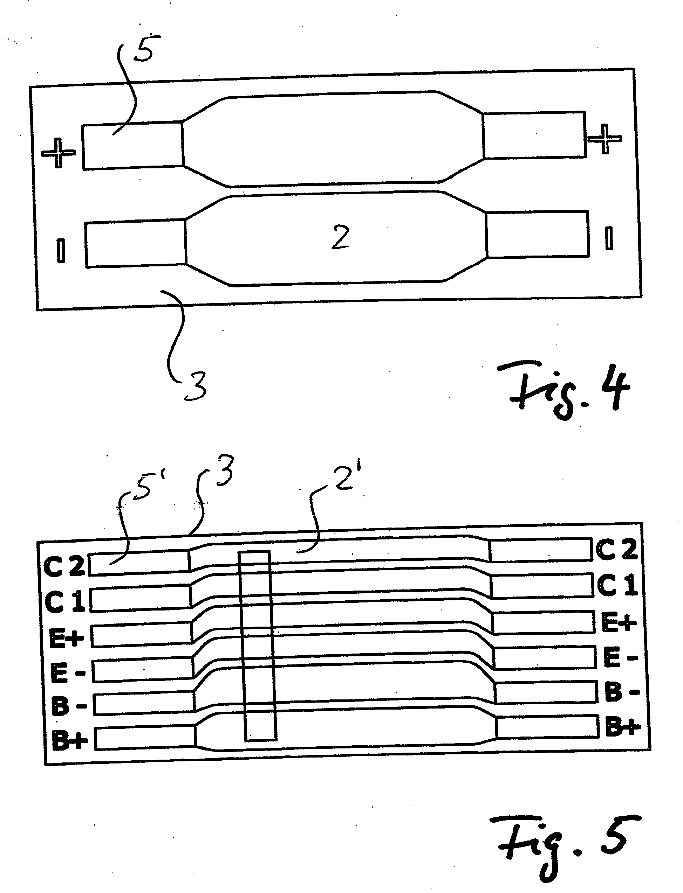

Die Figur 4 zeigt eine Draufsicht auf eine Seite der Leiterplatte 3, auf der Leiterbahnen 2 angeordnet sind. Wegen des verhältnismäßig großen Querschnitts der Leiterbahnen 2 dienen derartige Leiterbahnen dem Transport eines verhältnismäßig großen Stromes, der beispielsweise zum Antrieb eines starken Gleichstrommotors 10 geeignet ist. Auf der der Starkstrom führenden Leiterbahnen 2 gegenüberliegenden Seite der Leiterplatte 3 sind die Leiterbahnen 2' beispielsweise zur Steuerung eines Motors 10 angeordnet, wie dies in Figur 5 dargestellt ist. Die Querschnitte dieser Leiterbahnen 2' sind erheblich kleiner, als die der stromführenden Leiterbahnen 2, da hierfür im allgemeinen keine großen Ströme erforderlich sind.

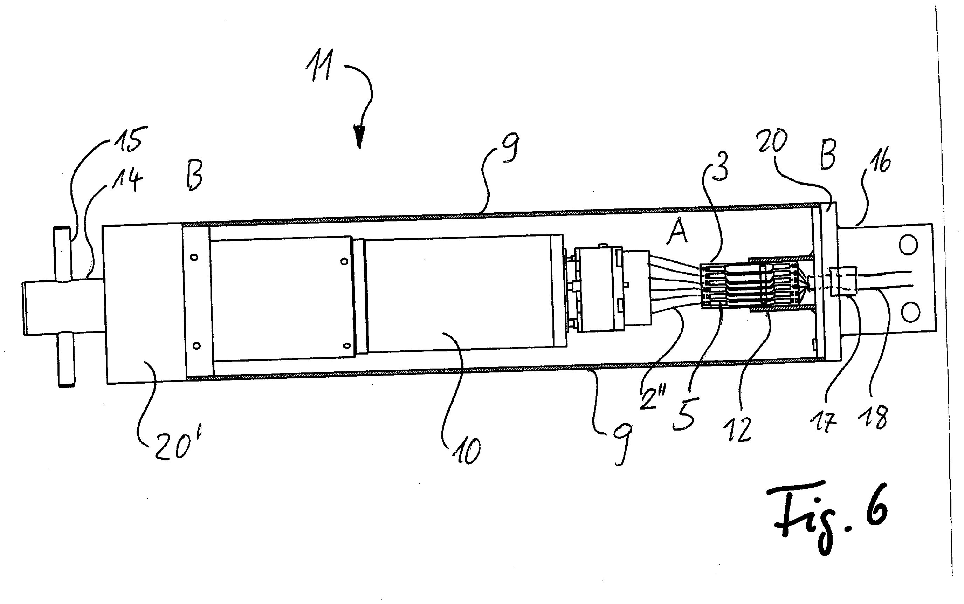

In Figur 6 wird eine schematische Darstellung eines Systems 11 gezeigt, in dem die tunnelförmige Durchführung 1 an einem Ende eines Gehäuses 9 angeflanscht ist. Das System 11 besteht im wesentlichen aus einem Gehäuse 9 an dessen beiden Seiten jeweils ein Flansch 20, 20' angeordnet ist, wobei der Flansch 20' dazu dient, die Welle 14 eines Motors 10 aufzunehmen. An der Welle 14 des Motors 10 sind eine Vielzahl von hier nicht gezeigten Propellerblättern, sowie ein Mitnehmer 15 angeordnet, die eine starke Flüssigkeitsströmung in der Flüssigkeit bei Rotation der Welle 14 erzeugen, wenn das gesamte System 11 in eine Flüssigkeit eingetaucht wird. Die Flüssigkeit bildet dabei beispielsweise das Medium im Raum B, der infolge der tunnelartigen Durchführung 1 vom Raum A hermetisch abgetrennt ist, wodurch im Innern des Raumes A so gut wie keine Feuchtigkeit messbar ist. Die erfindungsgemäße tunnelartige Durchführung 1 ist mittels eines Flansches 20 am Ende des Gehäuses 9 angeordnet. In dieser Darstellung ist die erfindungsgemäße tunnelförmige Durchführung 1 nur angedeutet, zeigt aber, dass auf der einen Seite des Flansches 20 ein mehradriges Kabels 18 in eine Verschraubung 17 eingeführt wird und die Kontakte 5 auf der Leiterplatte 3 mit elektrischen Leitungen 2", die zu einem Motor 10 führen, verbunden sind. Mit den elektrischen Leitungen 2" wird dem Motor 10 sowohl der Kraftstrom als auch die Steuersignale im hermetisch abgeschlossenen Raum A zugeführt.

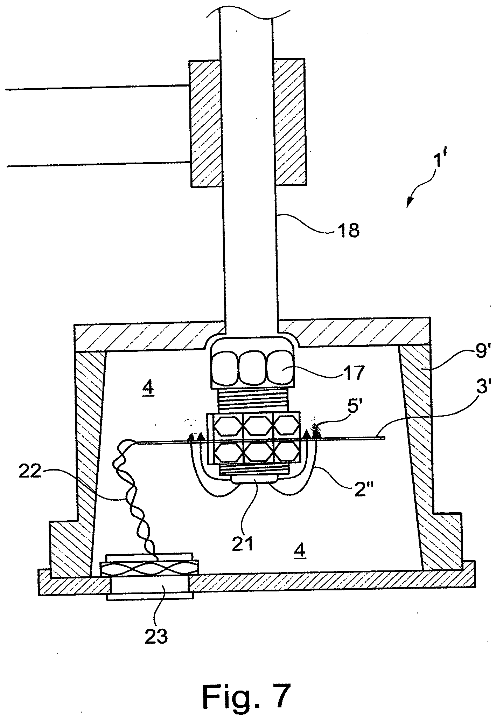

Die Figur 7 zeigt eine schematische Seitenansicht eines Ausführungsbeispiels im Querschnitt, bei der die Leiterplatte (3') quer zu Längsachse des Kabels 18 angeordnet ist. Das Kabel 18 weist eine Vielzahl einzelner Adern 2" mit einer Ummantelung als Isolierung 8 auf (s. Fig.1), die an der Leiterplatte 3' elektrisch leitend an vorbestimmten Kontakten 5 verbunden sind. Das Kabel 18 wird mittels einer Verschraubung 17 in das Gehäuse 9' so eingeführt, dass das Ende 21 der Ummantelung des Kabels 18 frei in den Hohlraum des Gehäuses 9 hineinragt. An der Leiterplatte 3' sind sowohl die Kraftstromleitungen als auch die Steuerleitungen elektrisch leitend mit den entsprechenden Leiterbahnen (hier nicht gezeigt) verbunden, sodass eine Unterbrechung der Kabeladern, bzw. der elektrischen Leiter 2" der Kabeladern mindestens einmal im Hohlraum des Gehäuses 9' unterbrochen sind und sowohl die Enden der Isolierung der Adern als auch das Ende der Ummantelung 19 der Adern von der Vergußmasse 4, die in der Regel aus einem speziellen Polyurethan besteht, erfasst werden. Von der Leiterplatte 3' weg führen im vorliegenden Ausführungsbeispiel zwei Steuerleitungen 22 zu einem Schaltelement 23, was beispielsweise eine Piezo-Tastatur sein kann. Entscheidend ist unter anderem auch hier, dass einerseits die Kabelleitung 2" mindestens einmal durch eine Leiterplatte 3' zu einem Schaltelement 23 unterbrochen wird und andererseits die Enden 21 der Kabelumwandlung und der Isolierung der einzelnen Adern von der Vergußmasse 4 hermetisch abgedichtet werden.

Zusammenfassend darf festgestellt werden, dass mit der vorliegenden Erfindung eine tunnelartige Durchführung 1, 1' von elektrischen Leitungen 2" bei hermetischer Trennung zweier Medien (A, B) vorgestellt wird, die häufig im Unterwasserbereich eine Anwendung finden, zum Beispiel zum Antrieb eines Unterwassermotors 10, der eine starke Flüssigkeitsströmung erzeugt. In der erfindungsgemäßen tunnelförmige Durchführung 1, 1' ist eine Leiterplatte 3, 3' angeordnet, die die elektrischen Leitungen 2" unterbricht und von einer Vergussmasse 4 zumindest teilweise umgeben ist, wodurch der Raum A eines Mediums, zum Beispiel Luft, vom Raum B eines anderen Mediums, zum Beispiel Wasser, hermetisch abgeschlossen und getrennt wird.

## Patentansprüche

1. Durchführung (1, 1')von stromführenden Leitungen, die mindestens zwei Medien (A, B) voneinander trennt und mindestens eine elektrische kabelförmige Leitung (2") von einem Medium (B) in ein anderes Medium (A) führt, wobei mindestens eine Leiterplatte (3, 3"), die die elektrische kabelförmige Leitung (2") innerhalb der Durchführung (1, 1') mindestens einmal in der Durchführung (1, 1') unterbricht, **dadurch geke nnzeichnet**, dass die Enden der Isolierung (8, 8') der einzelnen Adern eines Kabels (18) und der Ummantelung (19), sowie die elektrischen Kontakte (5, 5') auf der Leiterplatte (3, 3') mindestens teilweise von einer Vergußmasse (4) umgeben sind und die Innenwände (7) eines tunnelartigen Aufbaus (12) und die Oberfläche der Leiterplatte (3) mindestens teilweise mit der Vergussmasse (4) eine wasserdichte Haftschicht bilden, die lange Zeit beständig ist.

2. Durchführung nach Anspruch 1, **dadurch gekennzeichnet, dass** die gesamte Oberfläche der Leiterplatte (3, 3') mit einer Schicht eines speziellen Lackes (6) beaufschlagt ist.

3. Durchführung nach Anspruch 1, **gekennzeichnet durch** eine tunnelartige Konstruktion mit einem Aufbau (12), der in das Innere der Durchführung hineinragt, bei der an der nach innen weisenden Fläche eines Flansches (20) ein Rohr (12) angeordnet ist, und der Flansch (20) an einem Gehäuse (9,9') befestigt ist.

4. Durchführung nach Anspruch 1, **dadurch gekennzeichnet, dass** die Leiterplatte (3, 3') zumindest teilweise in die tunnelartige Konstruktion eingeführt ist, und die Leiterplatte (3, 3') mindestens teilweise von der Vergußmasse (4) umgeben ist.

5. Durchführung nach Anspruch 1, **dadurch gekennzeichnet, dass** die Vergussmasse (4) mit der Oberfläche der Leiterplatte (3, 3') und den Enden der Isolierung (8, 8') und der Ummantelung (19) eine feuchtigkeitsundurchlässige Verbindung eingeht.

6. Durchführung nach Anspruch 1, **dadurch gekennzeichnet, dass** die Lackschicht (6) mit der Vergussmasse (4) eine Verbindung bildet, die feuchtigkeitsundurchlässig ist und das Medium A vom Medium B sicher trennt.

7. Durchführung nach einem der vorangegangenen Ansprüche, **dadurch gekennzeichnet, dass** auf der nach innen weisenden Flanschfläche ein Rohr (12) angeordnet ist, dass mit einer Bohrung im Flansch (20) fluchtet.

8. Durchführung nach einem der vorangegangenen Ansprüche, **dadurch gekennzeichnet, dass** auf der nach außen weisenden Flanschfläche ein hohler Aufbau (16) angeordnet ist.

9. Durchführung nach einem der vorangegangenen Ansprüche, **dadurch gekennzeichnet, dass** auf der nach außen weisenden Flanschfläche eine Verschraubung (17) angeordnet ist, die ein mehradriges Kabel (18) aufnimmt.

10. Durchführung nach einem der vorangegangenen Ansprüche, **dadurch gekennzeichnet, dass** auf beiden Seiten der Leiterplatte (3, 3') elektrische Leiterbahnen (2,2') angeordnet sind, wobei auf der einen Seite der Leiterplatte (3,3') die Kraftstrom führenden Leitungen (2) und auf der anderen Seite die Steuerleitungen (2') angeordnet sind.

11. Durchführung nach Anspruch 7, **dadurch geke nnzeichnet**, dass die Leiterbahnen (2,2') auf beiden Seiten der Leiterplatte (3, 3') Verbindungsstellen (5, 5') aufweisen, an denen die zugehörigen Kabelenden elektrisch verbunden sind.

12. Durchführung nach einem der vorangegangenen Ansprüche, **dadurch gekennzeichnet, dass** die Ebene der Leiterplatte (3') in etwa senkrecht zur Kabelachse des Kabels (18) angeordnet ist.

13. Verfahren zur Herstellung einer absolut wasser- und feuchtigkeitsdichten Durchführung, die mindestens zwei Medien (A, B) voneinander trennt und mindestens eine elektrische kabelförmige Leitung (2") von einem Medium (B) in ein anderes Medium (A) führt, wobei mindestens eine Leiterplatte (3,3'), die elektrische kabelförmige Leitung (2") innerhalb der Durchführung (1,1') mindestens einmal unterbricht, **dadurch gekennzeichnet, dass** die Enden der Isolierung (8, 8') der einzelnen Adern eines Kabels (18) und der Ummantelung (19), sowie die elektrischen Kontakte (5, 5') auf der Leiterplatte (3, 3') mindestens teilweise mit einer Vergußmasse (4) umgeben werden und die Innenwände (7) eines tunnelartigen Aufbaus (12) und die Oberfläche der Leiterplatte (3) innerhalb der Durchführung (1) mindestens teilweise mit der Vergussmasse (4) eine wasserdichte Haftschicht bilden, die lange Zeit beständig bleibt.

14. Verfahren nach Anspruch 13, **dadurch gekennzeichnet, dass** eine auf der gesamten Oberfläche beschichteten Leiterplatte (3, 3') zumindest teilweise in einen rohrförmigen Aufbau (12) eingeführt wird.

15. Verfahren nach einem der vorangegangenen Ansprüche, **dadurch gekennzeichnet, dass** der Hohlraum des rohrförmigen Aufbaus (12) zumindest teilweise mit einer geeigneten Vergußmasse (4) vergossen wird, wobei mit der auf der gesamten Oberfläche der Leiterplatte (3, 3') aufgebrachten Schicht (6) mit der Vergußmasse (4) eine wasserdichte Verbindung gebildet wird.
